# EUROPEAN PATENT APPLICATION

(11) **EP 2 343 734 A1**
(43) Date of publication of application: **13.07.2011**
(21) Application number: 09807568.2
(22) Date of filing: 12.06.2009
(51) Int. Cl.: H01L 21/52, H01L 23/48

(54) **SEMICONDUCTOR DEVICE AND METHOD FOR MANUFACTURING THE SAME**

(30) Priority: 22.10.2008 JP 2008271639
(71) Applicant: Panasonic Corporation, Kadoma-shi Osaka 571-8501 (JP)
(72) Inventor:
(74) Representative: Grünecker, Kinkeldey, Stockmair & Schwanhäusser Anwaltssozietät
(86) International application number: PCT/JP2009/002680
(87) International publication number: WO 2010/047010

(57) **Abstract**

A semiconductor device includes a die pad having a surface on which a first solder bonding layer is formed, and made of metal; and a semiconductor element fixed on the first solder bonding layer on the die pad by a solder material made mostly of bismuth. The first solder bonding layer is made of a softer material than the solder material, a recess is formed in a part of the first solder bonding layer by pressing the solder material against the first solder bonding layer, and the solder material partially fills the recess.

## Description

### CROSS-REFERENCE TO RELATED APPLICATION

This is a continuation of PCT International Application PCT/JP2009/002680 filed on June 12, 2009, which claims priority to Japanese Patent Application No. 2008-271639 filed on October 22, 2008. The disclosures of these applications including the specifications, the drawings, and the claims are hereby incorporated by reference in its entirety.

### BACKGROUND

The present disclosure relates to semiconductor devices and methods for fabricating the same.

For example, a semiconductor device utilized for a power supply of an electronic device, such as a TV receiver, generally includes a die pad made of metal, and a semiconductor element (semiconductor chip) fixed on the die pad via a solder material.

Such a semiconductor device is achieved in the following manner: a spherical solder material is initially placed on a heated die pad; the placed solder material is spread on the die pad and molten; a semiconductor element is pressed onto the molten solder material; and the pressed semiconductor element is thereafter cooled so as to be fixed on the die pad by the solder material (see, e.g., Japanese Patent Publication No. 2002-156561).

### SUMMARY

In recent years, use of lead-free solder materials has been promoted. However, for a semiconductor device, in particular, a power semiconductor device, there is no alternative to a solder material used to fix a semiconductor element on a die pad. Therefore, solder materials made mostly of lead are even currently used, and there has been a demand for rapid use of lead-free solder materials.

However, when a semiconductor element is fixed on a die pad by a known lead-free tin (Sn)-silver (Ag)-copper (Cu) solder material, the solder material is again molten due to heat generated in mounting a semiconductor device on a printed wiring board because the melting point of the lead-free solder material is as low as 220°C. The molten solder material flows onto the semiconductor element, thereby causing shorting therebetween. Therefore, such a known lead-free solder material has failed to be employed as a material used to fix a semiconductor element on a die pad.

To address the above problem, lead-free solder materials having a high melting temperature have been investigated. However, use of such a lead-free solder material prevents a semiconductor element from being stably soldered onto a die pad because the melting temperature of the used material is high.

Specifically, since a semiconductor element is mounted on a solder material, a solder material having a high melting temperature can also essentially be heated only to a temperature low enough to prevent the semiconductor element from being thermally damaged. Consequently, the semiconductor element cannot be stably soldered onto the die pad.

An object of the present disclosure is to solve the problem mentioned above and allow a semiconductor element to be stably soldered onto a die pad.

In order to achieve the above object, a semiconductor device of the present disclosure is configured so that use of a solder material harder than a solder bonding layer formed on a die pad allows a recess (concave portion) to be formed in the solder bonding layer and allows the formed recess to be filled with part of the solder material.

Specifically, the semiconductor device of the present disclosure includes a die pad having a surface on which a first solder bonding layer is formed, and made of metal; and a semiconductor element fixed on the first solder bonding layer on the die pad by a solder material made mostly of bismuth. The first solder bonding layer is made of a softer material than the solder material, a recess is formed in a part of the first solder bonding layer by pressing the solder material against the first solder bonding layer, and the solder material partially fills the recess.

According to the semiconductor device of the present disclosure, a softer material than the solder material made mostly of bismuth is used for the first solder bonding layer formed on the die pad. Therefore, a recess can be formed in a part of the first solder bonding layer so as to be recessed toward the die pad by pressing the solder material against the first solder bonding layer. This allows the recess to be filled with the solder material. This increases the bonding area where the first solder bonding layer on the die pad is bonded to the solder material, resulting in an increase in the bond strength between the die pad and the solder material. As a result, the semiconductor element is stably soldered onto the die pad.

In the semiconductor device of the present disclosure, the first solder bonding layer is preferably made of silver or a metal made mostly of silver.

In the semiconductor device of the present disclosure, the solder material preferably contains bismuth, copper, and germanium.

In the semiconductor device of the present disclosure, the die pad is preferably made of copper or a metal made mostly of copper.

In the semiconductor device of the present disclosure, an opening is preferably formed in the recess of the first solder bonding layer to expose the die pad, and the solder material is preferably in contact with the surface of the die pad through the formed opening.

In this case, the solder material preferably enters a space located around the opening and between the die pad and the first solder bonding layer.

In the semiconductor device of the present disclosure, a second solder bonding layer is preferably formed on a surface of the semiconductor element opposed to the solder material, and the second solder bonding layer is preferably made of silver or a metal made mostly of silver.

In this case, an adhesion layer, an intermediate bonding layer, and a barrier layer are preferably formed between the semiconductor element and the second solder bonding layer sequentially from the semiconductor element toward the second solder bonding layer.

Furthermore, in this case, the adhesion layer is preferably made of chrome, the intermediate bonding layer is preferably made of an alloy of nickel and chrome, and the barrier layer is preferably made of nickel.

A method for fabricating the semiconductor device of the present disclosure includes acts of: (a) forming a recess in the first solder bonding layer by the spherical solder material pressing onto the first solder bonding layer formed on the surface of the die pad; (b) after the act (a), spreading the solder material on the first solder bonding layer; and (c) after the act (b), pressing the semiconductor element onto the spread solder material.

The method of the present disclosure preferably further includes an act of (d) before the act (a), heating the die pad.

In the method of the present disclosure, in the act (a), an opening is preferably formed in the recess formed in the first solder bonding layer to expose the die pad, and the solder material is preferably in contact with the surface of the die pad through the formed opening.

According to the semiconductor device of the present disclosure and the method for fabricating the same, the bonding area where the first solder bonding layer formed on the die pad is bonded to the solder material is increased, resulting in an increase in the bond strength between the die pad and the solder material. Therefore, the semiconductor element is stably soldered onto the die pad.

### BRIEF DESCRIPTION OF THE DRAWINGS

FIG. 1 is a perspective view illustrating a semiconductor device according to an embodiment of the present disclosure.
FIG. 2 is a plan view illustrating the semiconductor device according to the embodiment of the present disclosure.
FIG. 3 is a cross-sectional view taken along the line III-III in FIG. 2.
FIG. 4 is an enlarged cross-sectional view illustrating a region IV of the semiconductor device in FIG. 3.
FIG. 5 is a cross-sectional view illustrating one act in a method for fabricating the semiconductor device according to the embodiment of the present disclosure.
FIG. 6 is a cross-sectional view illustrating another act in the method for fabricating the semiconductor device according to the embodiment of the present disclosure.
FIG. 7 is an enlarged cross-sectional view illustrating a region VII of the semiconductor device in FIG. 6.
FIG. 8 is an enlarged cross-sectional view illustrating the region VII of the semiconductor device in FIG. 6 subsequent to the region VII illustrated in FIG. 7.
FIG. 9 is a cross-sectional view illustrating still another act in the method for fabricating the semiconductor device according to the embodiment of the present disclosure.
FIG. 10 is a cross-sectional view illustrating yet another act in the method for fabricating the semiconductor device according to the embodiment of the present disclosure.
FIG. 11 is a cross-sectional view illustrating a further act in the method for fabricating the semiconductor device according to the embodiment of the present disclosure.

### DETAILED DESCRIPTION

### (Embodiment)

An embodiment of the present disclosure will be described with reference to the drawings.

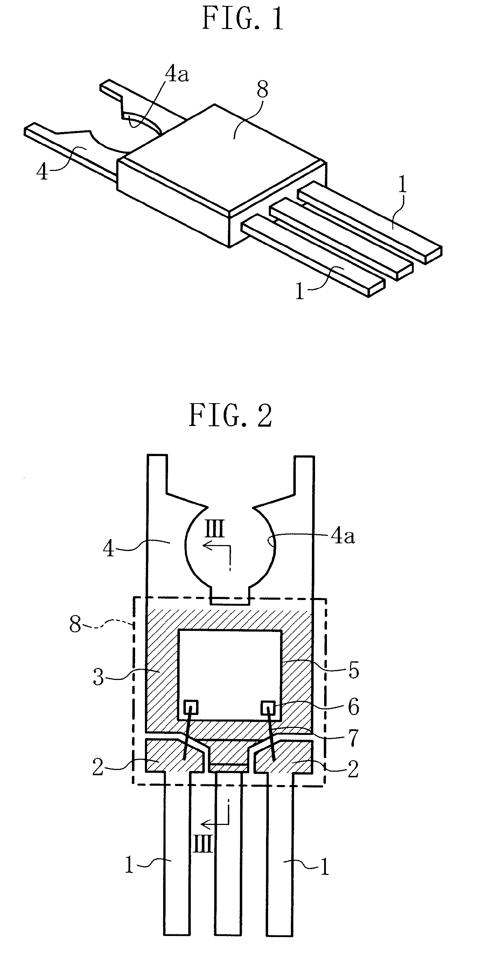

FIG. 1 illustrates a semiconductor device according to the embodiment of the present disclosure. The semiconductor device is utilized for, e.g., a power supply of a TV receiver. Furthermore, FIG. 2 illustrates a planar configuration of the semiconductor device. In FIG. 2, a resin encapsulant is not illustrated. A current ranging from approximately tens of amperes to approximately one hundred amperes flows through the semiconductor device used for the power supply. In order to prevent a corresponding semiconductor element from being damaged due to heat generated by this current, a sufficiently thick copper (Cu) leadframe is used which is formed with a plurality of outer leads 1, a plurality of inner leads 2, a die pad 3, and a heat dissipator 4 as illustrated in FIGS. 1 and 2. The heat dissipator 4 is formed integrally with the side of the die pad 3 furthest from the outer leads 1. Furthermore, the outer leads 1 are formed integrally with the corresponding inner leads 2, and a pair of one of the plurality of outer leads 1 and one of the plurality of inner leads 2 is formed integrally with the die pad 3.

As illustrated in FIG. 2, a semiconductor element (semiconductor chip) 5 is mounted on the die pad 3, and wires 7 made of, e.g., aluminum (Al) provide electrical connection between electrodes 6 formed on the semiconductor element 5 and the corresponding inner leads 2 which are not connected with the die pad 3.

The semiconductor element 5, the wires 7, the inner leads 2, and the die pad 3 are covered with a resin encapsulant 8 (not illustrated in FIG. 2).

The heat dissipator 4 is formed with a screw hole 4a. When a screw is screwed into the screw hole 4a so that the heat dissipator 4 is fixed to a heat dissipation mechanism (not illustrated) of the power supply, heat generated in the semiconductor element 5 can be dissipated to the heat dissipation mechanism through the die pad 3, the heat dissipator 4, and the screw.

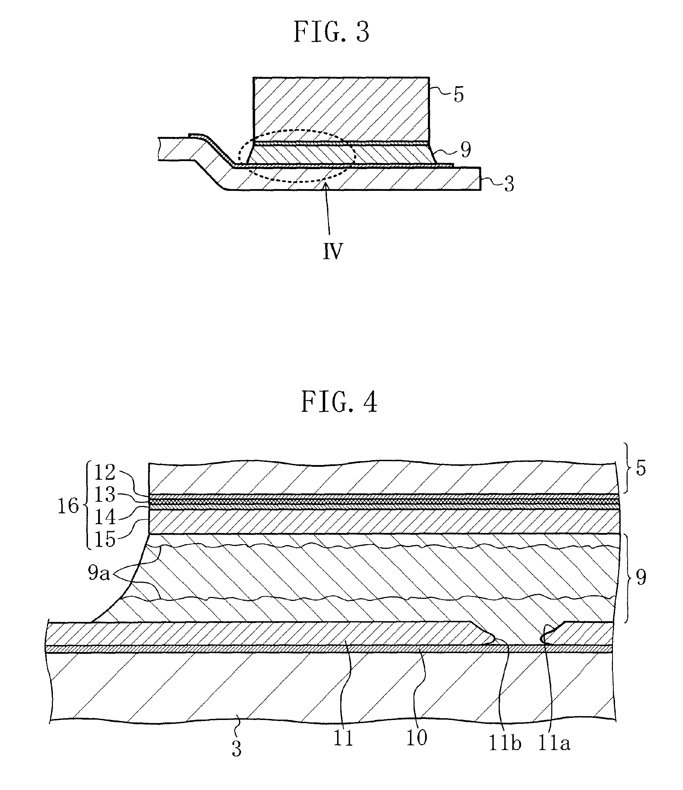

As illustrated in FIG. 3, the semiconductor element 5 is fixed on the die pad 3 by a solder material 9. Specifically, as illustrated in FIG. 4, an approximately 0.1-0.4-µm-thick active layer 10 made of copper, for example, is formed on the surface of the die pad 3 by vacuum deposition, sputtering, or any other method. In this embodiment, the die pad 3 includes the copper active layer 10. Furthermore, although copper is used for the outer leads 1, the inner leads 2, and the die pad 3, a material of the outer leads 1, inner leads 2, and die pad 3 is not limited only to copper. An alloy containing copper and silver (Ag) or cobalt (Co) may be used as the material.

An approximately 1-4-µm-thick first solder bonding layer 11 formed by plating and made of silver (Ag) is provided on the active layer 10. In fabricating a semiconductor device, the die pad 3, the active layer 10, and the first solder bonding layer 11 are treated as a three-layer structure.

A lower portion of the semiconductor element 5 is a semiconductor substrate made of, e.g., silicon (Si). An approximately 0.05-µm-thick adhesion layer 12 made of chrome (Cr), an approximately 0.05-µm-thick intermediate bonding layer 13 made of a nickel (Ni)-chrome (Cr) alloy, and an approximately 0.3-µm-thick barrier layer 14 made of nickel (Ni) are sequentially formed on the lower surface of the semiconductor substrate by vacuum deposition or sputtering. An approximately 0.5-5-µm-thick second solder bonding layer 15 made of silver by vacuum deposition or plating is formed on the lower surface of the barrier layer 14. Specifically, a back electrode 16 for the semiconductor element 5 includes the adhesion layer 12, the intermediate bonding layer 13, the barrier layer 14, and the second solder bonding layer 15.

Although silver is used for the first and second solder bonding layers 11 and 15, a material of these layers is not limited only to silver. An alloy containing silver and cobalt (Co) or copper (Cu) may be used as the material.

Furthermore, the adhesion layer 12 may include an alloy made mostly of chrome. The intermediate bonding layer 13 may include an alloy made mostly of a nickel-chrome alloy. The barrier layer 14 may include an alloy made mostly of nickel.

For the die pad 3 and the semiconductor element 5 which are configured as described above, a solder material 9 is interposed between the first solder bonding layer 11 on the die pad 3 and the second solder bonding layer 15 forming a portion of the back electrode 16 for the semiconductor element 5. Thus, the semiconductor element 5 is mounted on the die pad 3 and fixed thereto by the solder material 9. The reference character 9a illustrated in FIG. 4 denotes floating diffusions of silver diffused from the first and second solder bonding layers 11 and 15 both made of silver into the solder material 9.

As illustrated in FIG. 4, in fabricating a semiconductor device, a recess 11a is formed in the first solder bonding layer 11 by pressing the solder material 9 against the first solder bonding layer 11 because, in this embodiment, the hardness of the solder material 9 is greater than that of the first solder bonding layer 11. Furthermore, an opening 11b is formed in the bottom of the recess 11a to expose the active layer 10 located immediately below the recess 11a, i.e., the die pad 3. As such, the recess 11a is filled with lower part of the solder material 9, and the solder material 9 enters a space located around the opening 11b and between the die pad 3 and the first solder bonding layer 11.

As described above, the semiconductor device according to this embodiment is configured so that the recess 11a is filled with the solder material 9. This increases the bonding area where the first solder bonding layer 11 on the die pad 3 is bonded to the solder material 9, resulting in an increase in the bond strength between the first solder bonding layer 11 and the solder material 9. As a result, the semiconductor element 5 is stably soldered onto the die pad 3.

A method for fabricating a semiconductor device configured as described above will be described hereinafter with reference to the drawings.

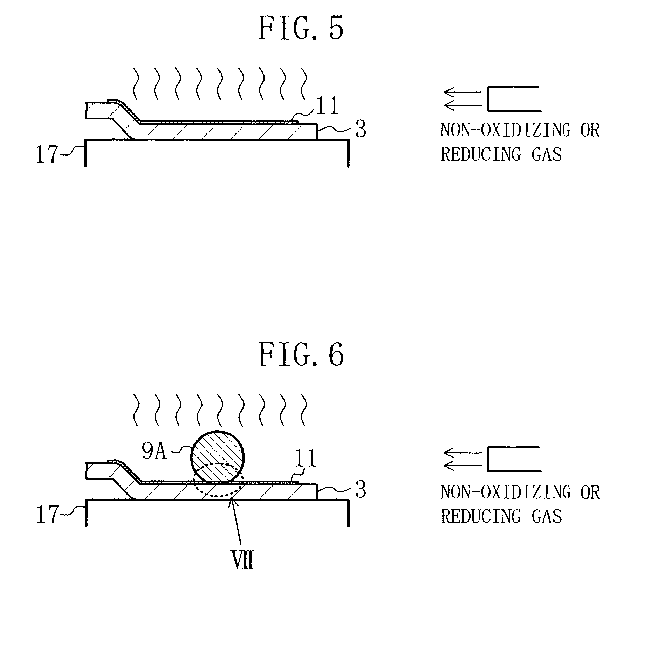

FIGS. 5-11 illustrate a cross-sectional configuration of a semiconductor device in acts of a method for fabricating the semiconductor device according to the first embodiment of the present disclosure in a sequential order.

First, as illustrated in FIG. 5, a die pad 3 having a surface on which an active layer 10 (not illustrated) and a first solder bonding layer 11 have been previously formed is placed on a heat block 17. Thereafter, the die pad 3 is heated to approximately 310°C in a reducing atmosphere, such as green gas (mixed gas of nitrogen (N₂) and hydrogen (H₂)), or a non-oxidizing atmosphere, such as a nitrogen (N₂) atmosphere.

Next, as illustrated in FIG. 6, a spherical solder material 9A is pressed onto the first solder bonding layer 11 on the die pad 3 heated in a reducing or non-oxidizing atmosphere. The solder material 9A is made mostly of bismuth (Bi) and includes copper (Cu), germanium (Ge), and other unavoidable components. The melting point of the solder material 9A is approximately 270°C. Here, the solder material 9A contains approximately 98% bismuth, approximately 2% copper, and approximately 0.06% germanium. Here, weight percentages are denoted by the symbol "%". Furthermore, the avoidable components include, e.g., steel (Fe), nickel (Ni), lead (Pb), zinc (Zn), aluminum (Al), cadmium (Cd), or arsenic (As). The content of each of the avoidable components contained in the solder material 9A is less than approximately 0.01 %.

The Mohs hardness of the solder material 9A is approximately 2.5 which is greater than that of the first solder bonding layer 11 directly below the solder material 9A, i.e., approximately 2.0.

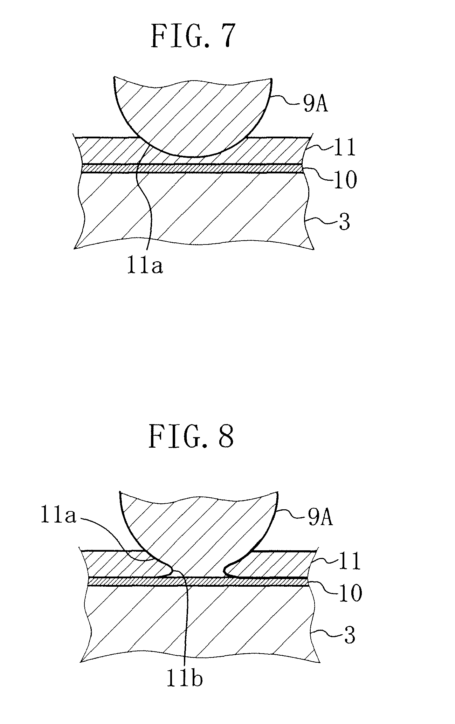

In view of the above, as illustrated in FIG. 7 which is an enlarged view of the region

VII in FIG. 6, when the spherical solder material 9A is pressed against the first solder bonding layer 11, a recess 11 a is formed in the first solder bonding layer 11, which is softer than the solder material 9A.

As illustrated in FIG. 8, when the solder material 9A is further pressed against the first solder bonding layer 11, an opening 11b is formed in the bottom of the recess 11a. Part of the solder material 9A will soon enter a space between the active layer 10 on the die pad 3 and the first solder bonding layer 11 through the formed opening 11b. Specifically, instead of part of the first solder bonding layer 11 located around the opening 11b, the solder material 9A spreads out to also fill a space located between the active layer 10 and the first solder bonding layer 11 and outside the opening 11b. In this situation, the active layer 10 is bonded to the part of the solder material 9A.

As described above, in this embodiment, lower part of the solder material 9A not only fills the recess 11a, but also is bonded to a wide region of the active layer 10 on the die pad 3 (including a region thereof located outside the opening 11b). This increases the bond strength between the lower part of the solder material 9A and the die pad 3.

The reason why the opening 11b is formed in a part of the first solder bonding layer 11 located under the solder material 9A, and the reason why the solder material 9A spreads out to fill a space outside the opening 11b so that, in this situation, part of the solder material 9A is bonded to the active layer 10 on the die pad 3 are not sufficiently clear yet. However, these reasons will be that, since the solder material 9A is made mostly of bismuth, silver forming the first solder bonding layer 11 has diffused into bismuth. As seen also from the fact that, as illustrated in FIG. 4, silver which has diffused from each of the first and second solder bonding layers 11 and 15 forms a floating diffusion 9a of silver inside the solder material 9, silver will tend to diffuse into bismuth.

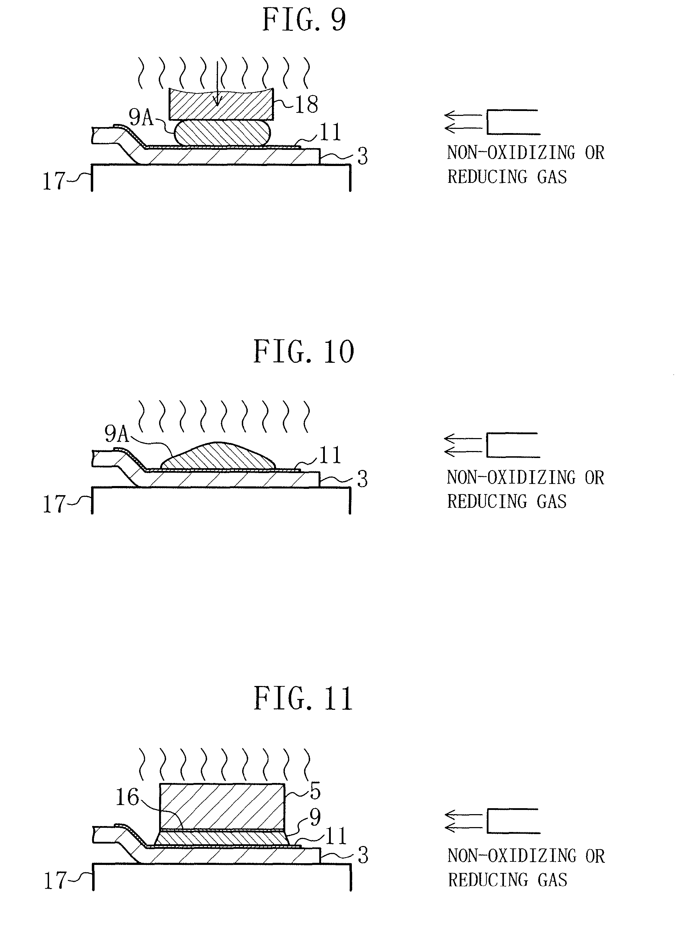

Next, as illustrated in FIG. 9, the spherical solder material 9A is spread by a pressure pin 18 with its lower part bonded to the die pad 3 while being heated in a reducing or non-oxidizing atmosphere.

Next, as illustrated in FIG. 10, the solder material 9A is molten so as to be gently raised while being heated in a reducing or non-oxidizing atmosphere.

Next, as illustrated in FIG. 11, a semiconductor element 5 is pressed onto the solder material 9A while being heated in a reducing or non-oxidizing atmosphere. Thereafter, in this situation, the temperature of the solder material 9A is reduced to harden the solder material 9A, thereby obtaining a solder material 9. As a result, a semiconductor device configured as illustrated in FIG. 4 is obtained. The back surface of the semiconductor element 5 is previously formed with a back electrode 16 including an adhesion layer 12, an intermediate bonding layer 13, a barrier layer 14, and a second solder bonding layer 15 which are configured as described above. Furthermore, nickel is used for the barrier layer 14 forming a portion of the back electrode 16. However, since the second solder bonding layer 15 made of silver is interposed between the barrier layer 14 and the solder material 9, nickel ions cannot diffuse into the solder material 9 in the act illustrated in FIG. 11, and therefore the melting temperature of the solder material 9 cannot be increased.

Moreover, the configuration of the back electrode 16 is not limited to the above-described configuration. As long as the back electrode 16 is made of an alloy, such as a gold (Au)-germanium (Ge) alloy, a gold (Au)-germanium (Ge)-antimony (Sb) alloy, or a titanium (Ti)-nickel (Ni)-silver (Ag) alloy, and can be generally used for semiconductor devices, the same advantages can be provided.

As described above, for the semiconductor device of the present disclosure, the first solder bonding layer 11 formed on the surface of the die pad 3 is made of a softer material than the solder material 9 made mostly of bismuth, and the solder material 9 is pressed against the first solder bonding layer 11. Thus, the recess 11 a can be formed in a part of the first solder bonding layer 11 so as to be recessed toward the die pad 3. This allows the recess 11a to be filled with the solder material 9. This increases the bonding area where the first solder bonding layer 11 on the die pad 3 is bonded to the solder material 9, resulting in an increase in the bond strength between the solder material 9 and the die pad 3. As a result, the semiconductor element 5 is stably soldered onto the die pad 3.

For the semiconductor device and method for fabricating the same according to the present disclosure, the bond strength between the die pad and the solder material is increased so that the semiconductor element is stably soldered onto the die pad. Therefore, the semiconductor device and method for fabricating the same are useful for semiconductor devices incorporated into electronic devices having high temperatures, in particular, under operating conditions, methods for fabricating the same, etc.

## Claims

1. A semiconductor device comprising:
a die pad having a surface on which a first solder bonding layer is formed, and made of metal; and
a semiconductor element fixed on the first solder bonding layer on the die pad by a solder material made mostly of bismuth,
wherein the first solder bonding layer is made of a softer material than the solder material,
a recess is formed in a part of the first solder bonding layer by pressing the solder material against the first solder bonding layer, and
the solder material partially fills the recess.

2. The semiconductor device of claim 1, wherein
the first solder bonding layer is made of silver or a metal made mostly of silver.

3. The semiconductor device of claim 1, wherein
the solder material contains bismuth, copper, and germanium.

4. The semiconductor device of claim 1, wherein
the die pad is made of copper or a metal made mostly of copper.

5. The semiconductor device of claim 1, wherein
an opening is formed in the recess of the first solder bonding layer to expose the die pad, and
the solder material is in contact with the surface of the die pad through the formed opening.

6. The semiconductor device of claim 5, wherein
the solder material enters a space located around the opening and between the die pad and the first solder bonding layer.

7. The semiconductor device of claim 1, wherein
a second solder bonding layer is formed on a surface of the semiconductor element opposed to the solder material, and the second solder bonding layer is made of silver or a metal made mostly of silver.

8. The semiconductor device of claim 7, wherein
an adhesion layer, an intermediate bonding layer, and a barrier layer are formed between the semiconductor element and the second solder bonding layer sequentially from the semiconductor element toward the second solder bonding layer.

9. The semiconductor device of claim 8, wherein
the adhesion layer is made of chrome, the intermediate bonding layer is made of an alloy of nickel and chrome, and the barrier layer is made of nickel.

10. A method for fabricating the semiconductor device of claim 1, the method comprising acts of:
(a) forming a recess in the first solder bonding layer by pressing the spherical solder material onto the first solder bonding layer formed on the surface of the die pad;
(b) after the act (a), spreading the solder material on the first solder bonding layer; and
(c) after the act (b), pressing the semiconductor element onto the spread solder material.

11. The method of claim 10 further comprising an act of
(d) before the act (a), heating the die pad.

12. The method of claim 10, wherein
in the act (a), an opening is formed in the recess formed in the first solder bonding layer to expose the die pad, and the solder material is in contact with the surface of the die pad through the formed opening.
